# FASCICULE DE BREVET EUROPEEN

(11) **EP 0 820 686 B1**
(45) Date de publication et mention de la délivrance du brevet: **18.10.2000**
(21) Numéro de dépôt: 96905667.0
(22) Date de dépôt: 25.03.1996
(51) Int. Cl.: H05K 5/00, G01V 15/00

(54) **REPONDEUR DE PETITES DIMENSIONS ET PROCEDE DE FABRICATION DE TELS REPONDEURS**
KOMPAKTER TRANSPONDER UND VERFAHREN ZU SEINER HERSTELLUNG
COMPACT TRANSPONDER AND METHOD FOR MAKING SAME

(30) Priorité: 12.04.1995 FR 9504392
(43) Date de publication de la demande: 28.01.1998
(73) Titulaire: Droz, François, 2300 La Chaux-de-Fonds (CH); EM Microelectronic-Marin SA, 2074 Marin (CH)
(72) Inventeur: Droz, François, 2300 La Chaux-de-Fonds (CH); EM Microelectronic-Marin SA, 2074 Marin (CH)
(74) Mandataire: Balsters, Robert
(86) Numéro de dépôt international: CH9600110
(87) Numéro de publication internationale: WO9632829

(56) Documents cités:
- WO-A-92/15105
- WO-A-92/22827
- DE-A- 3 446 585
- FR-A- 2 186 805
- US-A- 4 042 955
- US-A- 4 594 644
- US-A- 4 992 794
- US-A- 5 025 550
- US-A- 5 235 326

## Description

La présente invention concerne un répondeur de petites dimensions. On nomme répondeur (en anglais "transponder") un module électronique fonctionnant comme récepteur - émetteur. En général, un répondeur est agencé pour fournir un signal d'identification en réponse à un signal d'excitation reçu, lequel fournit l'énergie nécessaire pour permettre au répondeur d'engendrer le signal d'identification.

Plusieurs répondeurs de petites dimensions sont connus de l'art antérieur. Dans le document US 5 025 550, le répondeur décrit est formé d'une bobine reliée électriquement à un circuit électronique, cet ensemble étant disposé à l'intérieur d'un boîtier en verre enveloppant intégralement l'ensemble électronique.

Dans le document US 5 235 326, il est décrit également un répondeur formé par un ensemble électronique comprenant un circuit intégré relié à une bobine, cet ensemble étant situé à l'intérieur d'un boîtier fermé enveloppant intégralement l'ensemble électronique. Pour assurer la stabilité de l'ensemble électronique, il est prévu un liant à l'intérieur de ce boîtier.

Un dispositif similaire est également décrit dans le brevet US 4 992 794 où le boîtier est fermé par un bouchon. Une telle solution est aussi proposée dans la demande internationale de brevet WO 92/15105. Ce dernier document propose en outre d'autres modes de réalisation pour l'enrobage de l'ensemble électronique du répondeur. Il est notamment prévu un simple surmoulage de l'ensemble électronique ou de disposer l'ensemble électronique entre deux feuilles de plastique thermosoudées.

Finalement, un répondeur de même type est décrit dans la demande internationale de brevet WO 92/22827. Divers modes de réalisation du répondeur sont proposés dans ce document. Selon un mode de réalisation particulier (figure 4 de ce document), il est prévu d'introduire l'ensemble électronique, formé de la bobine reliée électriquement à un circuit électronique, à l'intérieur d'un tube comprenant dans sa partie supérieure et à l'intérieur de ce tube un anneau en matériau fusible. Cet anneau est fondu de manière à fermer l'ouverture d'introduction de l'ensemble électronique pour former le répondeur.

Tous les répondeurs décrits ci-avant présentent un inconvénient majeur étant donné que l'enrobage de l'ensemble électronique prévu nécessite un procédé de fabrication relativement complexe qui augmente le coût du répondeur.

De plus, dans tous les répondeurs décrits dans les divers documents cités ci-avant, il est très difficile d'assurer un remplissage total de l'enveloppe externe définissant un boîtier fermé entourant intégralement l'ensemble électronique prévu à l'intérieur de ce boîtier.

La présente invention se propose de pallier les inconvénients des répondeurs de l'art antérieur décrit ci avant. A cet effet, un but de l'invention est de fournir un répondeur bon marché dans lequel la protection de l'ensemble électronique est parfaitement assurée.

Un autre but de la présente invention est de fournir un procédé de fabrication de dispositifs électroniques, notamment de répondeurs, permettant de les fabriquer de manière industrielle pour un faible coût de production.

L'invention a donc pour objet un répondeur comprenant un ensemble électronique et un enrobage protégeant cet ensemble électronique. Ce répondeur est caractérisé en ce que l'enrobage est formé par une enveloppe externe, définissant une poche et présentant une ouverture, et un liant solidifié remplissant entièrement l'enveloppe et formant une surface externe du répondeur dans la région définie par le bord de ladite ouverture, l'ensemble électronique étant noyé dans le liant.

Grâce aux caractéristiques particulières du dispositif selon l'invention, l'ensemble électronique est correctement protégé par une enveloppe ouverte, c'est-à-dire présentant une ouverture par laquelle l'ensemble électronique et le liant ont pu être introduits, et par le liant de remplissage dans lequel l'ensemble électronique est noyé. Un tel répondeur se distingue de l'art antérieur décrit ci-avant en ce que l'enveloppe externe n'est pas entièrement fermée, ce qui évite au moins une opération lors du procédé de fabrication de ce dispositif. De plus, étant donné que le liant forme lui-même une surface externe du répondeur, il est aisé d'assurer un remplissage intégral de l'enveloppe, ce qui rend le répondeur compact et résistant. Ensuite, l'ensemble électronique est complètement enrobé par le liant, ce qui assure un positionnement stable et une protection totale.

Dans le domaine spécifique de l'enrobage d'éléments ou de circuits électroniques, on connaît du document DE 34 46 585 un procédé consistant à placer au fond d'un boîtier ouvert un circuit imprimé sur lequel est monté divers composants électroniques, puis à injecter pardessus une résine de protection qui remplit le boîtier. Le document US 4,042,955 divulgue quant à lui un procédé d'enrobage de dispositifs électriques. Le dispositif électrique est mis dans un boîtier en aluminium et un matériau d'enrobage isolant est apporté pour enrober ce dispositif électrique. Ensuite, le matériau d'enrobage est recouvert par une résine à faible viscosité.

Le premier procédé nécessite une installation d'injection avec des moules de fermeture individuels pour les boîtiers. Le second procédé ne permet pas d'obtenir une surface externe de la résine qui soit plane et lisse. De plus, il est difficile de doser la quantité de résine pour remplir entièrement le boîtier.

Un autre but de l'invention est de fournir un procédé de fabrication de dispositifs électroniques, notamment de répondeurs, qui soit peu onéreux et permette d'avoir un enrobage de qualité présentant une surface externe sans saillie ou irrégularité.

A cet effet l'invention a également pour objet un procédé de fabrication d'un dispositif électronique comprenant les étapes suivantes :
- apport d'une enveloppe, définissant une poche, ayant une ouverture supérieure,
- apport d'un réservoir disposé au-dessus de ladite enveloppe, ce réservoir communiquant avec la poche par l'ouverture supérieure et ayant au moins une ouverture de remplissage,
- apport d'un liant sous forme liquide dans le réservoir,
- apport d'un ensemble électronique dans la poche par l'ouverture supérieure prévue dans l'enveloppe,
- durcissement du liant apporté qui recouvre alors ledit ensemble électronique,
- séparation du dispositif électronique, formé par l'enveloppe et l'ensemble électronique noyé dans le liant solidifié, du réservoir.

Le procédé selon l'invention décrit ci-avant présente plusieurs avantages. Notamment, la présence du réservoir permet d'apporter le liant en quantité supérieure au liant nécessaire pour former le dispositif électronique selon l'invention. On élimine ainsi la question délicate du dosage du liant, tout en assurant un remplissage intégral de la poche définie par l'enveloppe du dispositif électronique.

Dans le cas où l'ouverture supérieure de l'enveloppe est relativement faible, le réservoir peut jouer un rôle d'entonnoir permettant ainsi un remplissage aisé de la poche. Ce remplissage nécessiterait un équipement complexe et coûteux sans la présence dudit réservoir. Selon un mode de réalisation particulier de l'invention, le réservoir est venu de matière avec l'enveloppe. De ce fait, le réservoir et l'enveloppe apportés initialement forment une seule pièce d'une même matière. Dans un tel cas, la séparation finale du dispositif électronique d'avec le réservoir peut être opérée par usinage, par exemple par un simple sectionnement, à l'aide d'une lame ou à l'aide d'un rayon laser, au niveau de l'ouverture supérieure de l'enveloppe du dispositif électronique.

Selon un mode de mise en oeuvre préféré, il est prévu d'associer plusieurs enveloppes à un réservoir commun, chacune de ces enveloppes présentant une ouverture supérieure débouchant sur ce réservoir commun. De ce fait, il est possible d'assurer le remplissage de plusieurs enveloppes par un apport unique de liant dans le réservoir commun. Cette étape sera avantageusement réalisée par le dépôt d'un fil de liant obturant les ouvertures de plusieurs enveloppes.

D'autres caractéristiques et avantages de l'invention seront mieux décrits à l'aide de la description suivante, faite en référence aux dessins annexés dans lesquels :
- la figure 1 représente schématiquement une coupe longitudinale d'un premier mode de réalisation d'un répondeur selon l'invention;
- la figure 2 représente un ensemble d'enveloppes associées a un réservoir commun pour une mise en oeuvre du procédé de fabrication de répondeurs selon l'invention;
- la figure 3 représente plusieurs ensembles électroniques reliés à un support commun pour ladite mise en oeuvre du procédé selon l'invention;
- les figures 4 et 5 représentent schématiquement, selon une représentation en coupe, deux états successifs survenant lors de ladite mise en oeuvre du procédé selon l'invention (l'ensemble électronique n'a pas été coupé);
- la figure 6 représente un deuxième mode de réalisation d'un répondeur obtenu par le procédé de fabrication décrit à l'aide des figures 2 à 5.

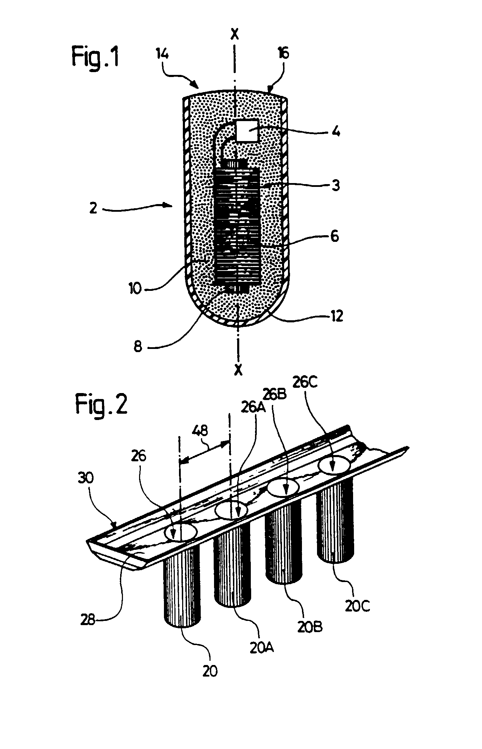

Sur la figure 1 est représenté un premier mode de réalisation d'un répondeur selon l'invention. Sur cette figure 1, le répondeur 2 est représenté selon une coupe longitudinale. Il comprend un ensemble électronique 3 formé d'un circuit intégré 4 relié électriquement à une bobine 6 enroulée autour d'un noyau 8. L'ensemble électronique 3 est incorporé dans un enrobage formé par un liant 10 dans lequel il est noyé et par une enveloppe 12 qui définit une paroi externe du répondeur 2.

Selon l'invention, il est prévu que l'enveloppe 12 n'enveloppe pas intégralement l'ensemble électronique 3. En effet, l'enveloppe 12 présente une ouverture 14 par laquelle l'ensemble électronique 3 et le liant 10 ont été introduits dans cette enveloppe. L'enveloppe 12 définit ainsi une poche ouverte, entièrement remplie par le liant 10 et l'ensemble électronique 3. On remarquera que, selon l'invention, une surface externe 16 du répondeur 2 est formée par le liant 10 lui-même. L'enveloppe 12 possède un axe de révolution X-X et la surface externe 16 peut être plane, bombée ou légèrement creuse.

Lors de la fabrication du répondeur 2, on veillera à ce que l'ensemble électronique 3 soit entièrement recouvert par le liant 10 dans la région de l'ouverture 14. Si après remplissage de l'enveloppe 12 par le liant 10 et après durcissement de ce liant, la partie de l'enveloppe 12 située dans la région de l'ouverture 14 n'est pas entièrement et correctement remplie par le liant 10, ou si la surface 16 formée par le liant présente des bossages et irrégularités formant des saillies vives, il est possible d'avoir recours à un appareil servant à lisser les surfaces externes de tels objets qui est connu de l'homme du métier. Dans le langage professionnel, on parle d'un adoucissage au tonneau rotatif.

A l'aide des figures 2 à 5, on décrira ci-après un mode de mise en oeuvre particulièrement avantageux d'un procédé de fabrication de dispositifs électroniques selon l'invention.

Dans le mode de mise en oeuvre susmentionné, il est prévu d'apporter au moins une enveloppe 20, définissant une poche, avec une ouverture supérieure 26, et un réservoir 28 disposé au-dessus de l'enveloppe 20. Le réservoir 28 comprend un trou inférieur correspondant à l'ouverture supérieure 26 de l'enveloppe 20. Ensuite, le réservoir 28 est ouvert dans sa partie supérieure pour permettre l'apport d'un liant dans ce réservoir. On remarquera que, de manière particulièrement avantageuse, le réservoir 28 est associé à plusieurs enveloppes 20, 20A, 20B et 20C présentant chacune une ouverture supérieure 26, 26A, 26B et 26C par laquelle les poches définies par ces enveloppes communiquent avec le réservoir commun 28. Seules quatre enveloppes ont été représentées à la figure 2, mais ceci n'est nullement limitatif. En effet, il est sans autre possible de prévoir un réservoir associé à un nombre quelconque d'enveloppes. A titre d'exemples, le diamètre de l'ouverture 26 est compris entre deux et trois millimètres, alors que les dimensions principales de la surface définie par le bord 30 de l'ouverture supérieure du réservoir 28 sont supérieures, la largeur ayant environ 5 à 6 mm et la longueur pouvant atteindre plusieurs centimètres suivant le nombre d'enveloppes prévues.

Lorsque les dimensions principales de l'ouverture 26 sont relativement petites, notamment inférieures à 5 mm, le réservoir 28, joue également le rôle d'entonnoir pour le liant apporté. En effet, le liant apporté dans le réservoir 28, lors d'une étape du procédé décrit ici, est formé par un liquide visqueux. Etant donné la viscosité du liant apporté, les gouttes déposées ou la masse de liant déposée dans le réservoir 28 présentent des dimensions supérieures aux dimensions des ouvertures supérieures des enveloppes, notamment de la moindre dimension principale de ces ouvertures.

Lorsque les ouvertures 26, 26A, 26B et 26C sont de petites dimensions, le liant, apporté sous forme de liquide visqueux dans la région définies par chacune de ces ouvertures, pénètre dans les poches définies par les enveloppes- 20, 20A, 20B et 20C. Le réservoir 28 a effectivement une fonction de réservoir de liant durant l'intervalle de temps nécessaire au remplissage desdites poches.

Suite à ce qui vient d'être mentionné ci-dessus, on remarquera donc que le réservoir 28 joue premièrement un rôle de réservoir pour le liant apporté sous forme de liquide visqueux et deuxièmement d'entonnoir pour le remplissage des poches définies par les enveloppes apportées avec le réservoir 28. Ces deux fonctions sont particulièrement nécessaires et avantageuses pour la fabrication de dispositifs électroniques, notamment de répondeurs, de petites dimensions.

On remarquera que les enveloppes 20, 20A, 20B et 20C sont venues de matière avec le réservoir 28. Le réservoir 28 et les enveloppes 20, 20A, 20B et 20C forment donc une seule pièce d'une même matière. Toutefois, dans une variante de mise en oeuvre, il est possible de prévoir que le réservoir 28 soit matériellement séparé des enveloppes apportées.

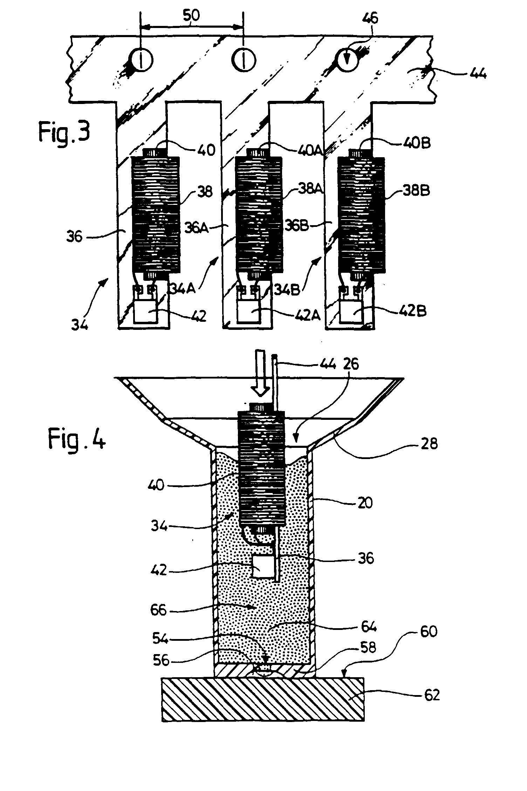

Sur la figure 3 sont représentés plusieurs ensembles électroniques 34, 34A, 34B formés chacun par un substrat 36, 36A, 36B sur lequel est agencée une bobine 38, 38A, 38B enroulée sur un noyau 40, 40A, 40B. Chaque bobine est reliée électriquement à un circuit intégré 42, 42A et 42B. A titre d'exemple, chaque ensemble électronique 34, 34A et 34B définit un dispositif électronique d'identification de personnes ou d'objets.

L'ensemble des substrats 36, 36A et 36B sont reliés à un support commun 44, lequel présente des trous de positionnement 46. Les ensembles électroniques 34, 34A et 34B sont disposés régulièrement le long du support 44, la distance 50 entre deux ensembles électroniques étant égale à la distance 48 séparant deux enveloppes voisines. Ainsi, selon l'invention, il est prévu d'apporter une pluralité d'ensembles électroniques reliés à un support commun, le nombre de ces ensembles électroniques apportés correspondant au nombre d'enveloppes apportées. De ce fait, il est aisément possible d'introduire simultanément la pluralité d'ensembles électroniques dans la pluralité d'enveloppes correspondantes. Ainsi, une fois le liant apporté dans le réservoir 28, les ensembles électroniques sont apportés et introduits simultanément dans les poches définies par les enveloppes au moins partiellement remplies de liant, comme cela est représenté à la figure 4. Sur cette figure 4, l'enveloppe 20 et le réservoir 28 sont représentés en coupe, l'enveloppe 20 étant coupée longitudinalement alors que le réservoir 28 est -coupé transversalement.

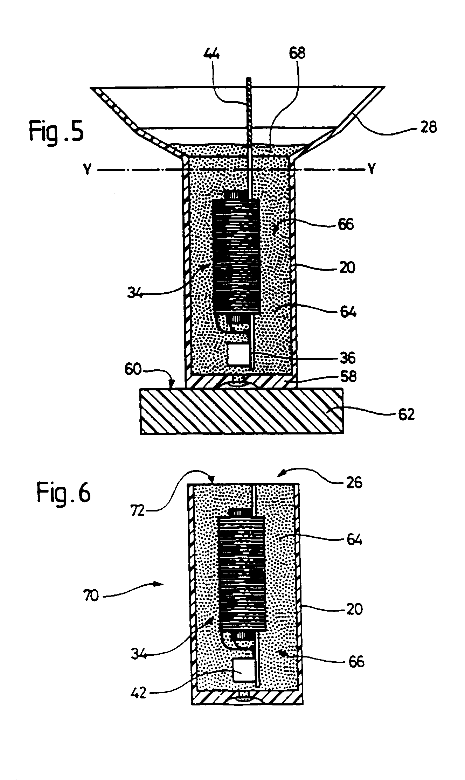

Par la suite, on se référera aux figures 4 et 5 pour la description du mode de mise en oeuvre du procédé selon l'invention décrit ici.

Un trou 54 est prévu dans la région inférieure de l'enveloppe 20. De plus, le trou 54 débouche sur un évidement externe 56 formé dans le fond 58 de l'enveloppe 20. Le trou 54 a une fonction d'orifice pour l'échappement de l'air lors de l'introduction du liant dans l'enveloppe 20. L'évidement 56 est prévu pour récupérer du liant pouvant s'écouler par le trou 54 lors du remplissage de l'enveloppe 20. Cependant, afin de limiter la quantité de liant pouvant s'échapper par le trou 54, -il est prévu, dans une variante avantageuse du mode de mise en oeuvre décrit ici, de mettre en appui le fond 58 contre une surface de travail 60 lors de l'introduction de l'ensemble électronique 34, comme cela est représenté à la figure 4. A titre d'exemple, la surface 60 forme la surface supérieure d'un bloc 62 en silicone. Ainsi, le liant 64 remplit entièrement l'enveloppe 20 lors de l'introduction de l'ensemble électronique 34, comme cela est représenté à la figure 5.

Une fois l'ensemble électronique 34 complètement introduit dans la poche 56 définie par l'enveloppe 20, un surplus de liant apporté est récolté par le réservoir 28. Le réservoir 28 a donc une troisième fonction, à savoir celle de récupérer un surplus de liant apporté, ce qui permet de garantir un remplissage intégral de la poche 66 par le liant 64 sans devoir garantir un dosage très précis lors de l'apport du liant.

Ensuite, le liant 64 se solidifie pour former une masse compacte dans laquelle est noyé l'ensemble électronique 34. On notera que pendant la phase de solidification du liant 64, il est possible de maintenir le fond 58 de l'enveloppe 28 en appui contre la surface 60 du bloc 62 ou alors de retirer le bloc 62 étant donné qu'il n'y a plus de surpression exercée sur le liant 64, comme c'est le cas lors de l'introduction de l'ensemble électronique 34 dans la poche 66. On remarquera que l'effet de surpression engendrée par l'introduction de l'ensemble électronique 34 dans la poche 66 est particulièrement présent lorsque les dimensions de la section de la bobine introduite correspond sensiblement aux dimensions de l'ouverture supérieure 26 de l'enveloppe 20.

Une fois l'ensemble électronique 34 introduit dans la poche 66 et le liant 64 solidifié au moins partiellement, il est prévu de séparer l'enveloppe 20, servant à former le dispositif électronique, du réservoir 28. Pour ce faire, on prévoit dans le présent mode de mise en oeuvre un sectionnement au niveau de la ligne de coupe Y-Y. Ce sectionnement peut être réalisé de diverses manières et par exemple à l'aide d'une lame ou d'une source de chaleur, tel un faisceau laser. Lors de ce sectionnement, le substrat 36 de l'ensemble électronique 34 est séparé du support 44, lequel reste avec le réservoir 28 et le liant résiduel 68.

On obtient alors un dispositif électronique, notamment un répondeur 70, tel que représenté en coupe à la figure 6. Le répondeur 70, définissant un deuxième mode de réalisation d'un dispositif selon l'invention, présente une enveloppe 20 définissant une paroi externe de ce répondeur 70. Ensuite, l'enveloppe 20 forme une poche ouverte 66, cette enveloppe 20 présentant une ouverture 26. La surface 72 du répondeur 70 dans la région de l'ouverture 26 est formée par le liant 64 solidifié dans lequel est noyé l'ensemble électronique 34.

On notera que la forme géométrique de la section du répondeur 70 peut être quelconque, la forme circulaire représentée à la figure 2 n'étant nullement limitative.

On notera encore que l'enveloppe 20 est par exemple en matière plastique et que le liant 64 est formé notamment par une colle à deux composants, par exemple une résine époxy, une résine acrylique ou encore une résine polyuréthane. Dans le cas d'une résine époxy, le procédé de fabrication décrit ci-avant est réalisé sensiblement à température ambiante, On obtient ainsi un dispositif électronique compacte et plein sans pour autant avoir recours à une technique d'enrobage à chaud qui peut être nuisible pour le circuit imprimé 42.

Le réservoir prévu dans le procédé de fabrication d'un dispositif électronique selon l'invention peut présenter diverses structures différentes. Il est notamment possible de prévoir que ce réservoir soit formé par diverses alvéoles définissant des entonnoirs respectifs pour les enveloppes associées à ce réservoir.

Selon une variante du mode de mise en oeuvre du procédé décrit ci-avant, le réservoir est fermé après l'apport des ensembles électroniques de manière à ce qu'une surpression puisse être engendrée dans le volume défini par les enveloppes et le réservoir.

On notera que le liant peut, selon deux variantes, être apporté avant la fermeture du réservoir ou après celle-ci par une ouverture de remplissage permettant d'apporter le liant sous pression. Dans ce dernier cas, il est notamment possible de prévoir un remplissage complet du réservoir dont les dimensions sont réduites pour limiter la quantité de liant résiduel.

On notera aussi que le liant peut de manière générale être apporté avant ou après les ensembles électroniques.

Selon un autre mode de mise en oeuvre du procédé selon l'invention, il est prévu de démouler le liant solidifié dans les enveloppes et le réservoir, notamment à l'aide du support 44 dans une variante utilisant des éléments semblables à ceux représentés aux figures 2 et 3, et ensuite de séparer le liant incorporant individuellement les ensembles électroniques du liant résiduel solidifié dans le réservoir. Dans ce cas-ci, le dispositif obtenu n'a pas d'enveloppe externe.

On remarquera finalement que le procédé selon l'invention est parfaitement adapté à la production en grande série de dispositifs électroniques dans lesquels les ensembles électroniques sont parfaitement protégés. Toutefois, le procédé selon l'invention peut sans autre être utilisé pour la production pièce à pièce d'un dispositif électronique. Dans ce cas, il est prévu un réservoir propre à chaque enveloppe.

## Revendications

1. Procédé de fabrication d'un dispositif électronique (70) comprenant les étapes suivantes :
- apport d'une enveloppe (20) définissant une poche (66) et ayant une ouverture supérieure (26);
- apport d'un réservoir (28) disposé au-dessus de ladite enveloppe, ce réservoir communiquant avec ladite poche par ladite ouverture supérieure et ayant au moins une ouverture de remplissage;
- apport d'un liant (64) sous forme liquide dans ledit réservoir;
- apport d'un ensemble électronique (34) dans ladite poche par ladite ouverture supérieure;
- durcissement dudit liant qui recouvre alors ledit ensemble électronique;
- séparation dudit dispositif, formé par ladite enveloppe et ledit ensemble électronique noyé dans ledit liant solidifié, dudit réservoir.

2. Procédé selon la revendication 1, caractérisé en ce que la quantité dudit liant (64) apporté est supérieure à la quantité de ce liant incorporée dans ledit dispositif (70) résultant après ladite étape de séparation, cette séparation étant opérée par un sectionnement au niveau de ladite ouverture supérieure (26) de ladite enveloppe (20).

3. Procédé selon la revendication 2, caractérisé en ce que ledit réservoir (28) est venu de matière avec ladite enveloppe (20), ledit réservoir et ladite enveloppe initialement apportés formant une seule pièce d'une même matière.

4. Procédé selon l'une des revendications 1 à 3, caractérisé en ce que ladite enveloppe (20) apportée présente un trou (54) dans sa partie inférieure.

5. Procédé selon la revendication 4, caractérisé en ce que ledit trou (54) débouche sur un évidement externe (56) agencé dans ladite enveloppe (20).

6. Procédé selon la revendication 4 ou 5, caractérisé en ce que ledit trou (54) est fermé du côté externe à ladite enveloppe (20) par des moyens d'obturation lors de l'apport dudit ensemble électronique (34) dans ladite poche (66) formée par ladite enveloppe.

7. Procédé selon l'une des revendications précédentes, caractérisé en ce que ledit réservoir (28) fait office d'entonnoir pour le remplissage de ladite poche par ledit liant (64), le contour (30) de l'ouverture de remplissage dudit réservoir définissant une surface dont les deux dimensions principales sont supérieures au moins à la moindre dimension de l'ouverture supérieure (26) de ladite enveloppe.

8. Procédé selon l'une des revendications précédentes, dans lequel il est prévu de fabriquer simultanément plusieurs dispositifs, caractérisé en ce que plusieurs enveloppes (20, 20A, 20B, 20C) sont apportées avec un seul réservoir commun (28) communiquant avec les poches, définies par lesdites enveloppes, par les ouvertures supérieures (26, 26A, 26B, 26C) de ces enveloppes, plusieurs ensembles électroniques (34, 34A, 34B) étant apportés et introduits respectivement dans lesdites poches.

9. Procédé selon la revendication 8, caractérisé en ce que lesdits ensembles électroniques (34, 34A, 34B) sont reliés initialement entre eux par un support (44), ces ensembles électroniques étant agencés sous ledit support avec un espacement régulier (50) correspondant à l'espacement (48) desdites enveloppes apportées (20, 20A, 20B, 20C), lesdits ensembles électroniques étant introduits simultanément dans lesdites poches à l'aide dudit support, ce support étant séparé de ces ensembles électroniques lors de ladite étape de séparation dans laquelle les dispositifs, formés respectivement par lesdites enveloppes et lesdits ensembles électroniques noyés dans ledit liant remplissant ces enveloppes, sont séparés dudit réservoir commun.

10. Répondeur (2; 70) susceptible d'être obtenu selon le procédé de fabrication d'une quelconque des revendications 1 à 9, comprenant un ensemble électronique (3; 34) et un enrobage (10, 12; 20, 64) protégeant cet ensemble électronique, caractérisé en ce que ledit enrobage est formé par une enveloppe externe (12; 20), définissant une poche et présentant une ouverture, et un liant solidifié remplissant entièrement ladite enveloppe et formant une surface externe dudit répondeur dans la région définie par le bord de ladite ouverture, ledit ensemble électronique étant noyé dans ledit liant.

11. Répondeur selon la revendication 10, caractérisé en ce que ladite enveloppe (20) présente, dans une région située à une extrémité opposée à ladite ouverture, un trou (54) de faible section.

12. Répondeur selon la revendication 11, caractérisé en ce que ledit trou (54) débouche sur un évidement externe (56) formé dans ladite enveloppe.

13. Répondeur selon l'une des revendications 10 à 12, caractérisé en ce que ledit liant (10; 20) est constitué par une colle à deux composants.

14. Répondeur selon l'une des revendications 10 à 13, caractérisé en ce que ladite enveloppe (12; 20) est en matière plastique.

15. Répondeur selon l'une des revendications 10 à 14, caractérisé en ce que ledit ensemble électronique est formé par un circuit intégré (4; 42) et une bobine (6; 40) reliés électriquement.

## Patentansprüche

1. Verfahren zum Herstellen einer elektronischen Vorrichtung (70), das die folgenden Schritte umfaßt:
- Bereitstellen einer Hülle (20), die eine Tasche (66) definiert und eine obere Öffnung (26) besitzt;
- Bereitstellen eines Behälters (28), der über der Hülle angeordnet ist, mit der Tasche durch die obere Öffnung in Verbindung steht und wenigstens eine Befüllungsöffnung besitzt;
- Bereitstellen eines Bindemittels (64) in flüssiger Form in dem Behälter;
- Zuführen einer elektronischen Einheit (34) in die Tasche durch die obere Öffnung;
- Aushärten des Bindemittels, das dann die elektronische Einheit bedeckt;
- Trennen der aus der Hülle und aus der in das verfestigte Bindemittel eingetauchten elektronischen Einheit gebildeten Vorrichtung vom Behälter.

2. Verfahren nach Anspruch 1, dadurch gekennzeichnet, daß die Menge des bereitgestellten Bindemittels (64) größer als die Menge des Bindemittels ist, die in der nach dem Trennschritt sich ergebenden Vorrichtung (70) enthalten ist, wobei diese Trennung durch eine Unterteilung auf Höhe der oberen Öffnung (26) der Hülle (20) erfolgt.

3. Verfahren nach Anspruch 2, dadurch gekennzeichnet, daß der Behälter (28) aus demselben Material wie die Hülle (20) gebildet ist, wobei der Behälter und die Hülle, die anfangs bereitgestellt werden, ein einziges Teil aus demselben Material bilden.

4. Verfahren nach einem der Ansprüche 1 bis 3, dadurch gekennzeichnet, daß die bereitgestellte Hülle (20) in ihrem unteren Teil ein Loch (54) aufweist.

5. Verfahren nach Anspruch 4, dadurch gekennzeichnet, daß das Loch (54) in eine äußere Aussparung (56) mündet, die in der Hülle (20) ausgebildet ist.

6. Verfahren nach Anspruch 4 oder 5, dadurch gekennzeichnet, daß das Loch (54) auf der äußeren Seite der Hülle (20) durch Verschlußmittel verschlossen ist, wenn die elektronische Einheit (34) der aus der Hülle gebildeten Tasche (66) zugeführt wird.

7. Verfahren nach einem der vorangehenden Ansprüche, dadurch gekennzeichnet, daß der Behälter (28) als Trichter für die Befüllung der Tasche mit dem Bindemittel (64) dient, wobei der Umriß (30) der Befüllungsöffnung des Behälters eine Oberfläche definiert, deren zwei Hauptabmessungen wenigstens größer als die halbe Abmessung der oberen Öffnung (26) der Hülle sind.

8. Verfahren nach einem der vorangehenden Ansprüche, bei dem vorgesehen ist, gleichzeitig mehrere Vorrichtungen herzustellen, dadurch gekennzeichnet, daß mehrere Hüllen (20, 20A, 20B, 20C) mit einem einzigen gemeinsamen Behälter (28), der mit den durch die Hüllen und durch die oberen Öffnungen (26, 26A, 26B, 26C) dieser Hüllen definierten Taschen in Verbindung steht, bereitgestellt werden, wobei den jeweiligen Taschen mehrere elektronische Einheiten (34, 34A, 34B) zugeführt und in diese eingeführt werden.

9. Verfahren nach Anspruch 8, dadurch gekennzeichnet, daß die elektronischen Einheiten (34, 34A, 34B) anfangs über einen Träger (44) miteinander verbunden sind, wobei diese elektronischen Einheiten unter dem Träger mit einem regelmäßigen Zwischenraum (50) angeordnet sind, der dem Zwischenraum (48) der bereitgestellten Hüllen (20, 20A, 20B, 20C) entspricht, wobei die elektronischen Einheiten mit Hilfe des Trägers gleichzeitig in die Taschen eingeführt werden, wobei dieser Träger im Trennschritt, in dem die aus den Hüllen und aus den in das diese Hüllen füllende Bindemittel eingetauchten elektronischen Einheiten gebildeten Vorrichtungen vom gemeinsamen Behälter getrennt werden, von diesen elektronischen Einheiten getrennt wird.

10. Antwortsender (2; 70), der mit dem Herstellungsverfahren nach einem der Ansprüche 1 bis 9 erhalten werden kann, mit einer elektronischen Einheit (3; 34) und einer Umhüllung (10, 12; 20, 64), die diese elektronische Einheit schützt, dadurch gekennzeichnet, daß die Umhüllung durch eine äußere Hülle (12; 20), die eine Tasche definiert und eine Öffnung aufweist, und durch ein verfestigtes Bindemittel, das die Hülle vollständig füllt und eine äußere Oberfläche des Antwortsenders in dem durch den Rand der Öffnung definierten Bereich bildet, gebildet ist, wobei die elektronische Einheit in das Bindemittel getaucht ist.

11. Antwortsender nach Anspruch 10, dadurch gekennzeichnet, daß die Hülle (20) in einem Bereich, der sich an dem der Öffnung gegenüberliegenden Ende befindet, ein Loch (54) mit kleinem Querschnitt aufweist.

12. Antwortsender nach Anspruch 11, dadurch gekennzeichnet, daß das Loch (54) in eine in der Hülle gebildete äußere Aussparung (56) mündet.

13. Antwortsender nach einem der Ansprüche 10 bis 12, dadurch gekennzeichnet, daß das Bindemittel (10; 20) durch einen Zweikomponentenklebstoff gebildet ist.

14. Antwortsender nach einem der Ansprüche 10 bis 13, dadurch gekennzeichnet, daß die Hülle (12; 20) aus Kunststoff besteht.

15. Antwortsender nach einem der Ansprüche 10 bis 14, dadurch gekennzeichnet, daß die elektronische Einheit aus einer integrierten Schaltung (4; 42) und aus einer Spule (6; 40), die elektrisch verbunden sind, gebildet ist.

## Claims

1. Process of manufacturing a device (70) characterized in that it comprises the following steps :
- providing an envelope (20), defining a pocket (66) and having an upper opening (26);
- providing a reservoir (28) disposed above said envelope, this reservoir communicating with said pocket by said upper opening and having at least one feeling opening;
- providing a binding (64) in liquid form in said reservoir;
- providing an electronic arrangement (34) in said pocket by said upper opening;
- hardening of said binding,
- separation of said device, formed by said envelope and said electronic arrangement embedded in said solidified binding, from said reservoir.

2. Process according to claim 1, characterized in that the quantity of said binding (64) provided is greater than a quantity of this binding incorporated in said device (70) resulting after said separation step, this separation being effectuated by a sectioning at the level of said upper opening (26) of said envelope (20).

3. Process according to claim 2, characterized in that said reservoir (28) is made from the same material as and integral with said envelope (20), said initially provided reservoir and envelope forming a single piece of a same material.

4. Process according to one of claim 1 to 3, characterized in that said provided envelope (20) presents a hole in its lower part.

5. Process according to claim 4, characterized in that said hole (54) opens into an external recess (56) provided in said envelope (20).

6. Process according to claim 4 or 5, characterized in that said hole (54) is closed on the external side of said envelope (20) by sealing means during the provision of said electronic arrangement (34) in said pocket (66) formed by said envelope.

7. Process according to one of the preceding claims, characterized in that said reservoir (28) acts as funnel for the filling of said pocket by said binding (64), a contour (30) of the filling opening of said reservoir defining a surface whose two principal dimensions are greater than at least the smallest dimensions of the upper opening (26) of said envelope.

8. Process according to one of the preceding claims, by which it is envisaged to simultaneously manufacture several devices, characterized in that several envelopes (20, 20A, 20B, 20C) are provided with a single common reservoir (28) communicating with the pockets, defined by said envelopes, by the upper openings (26, 26A, 26B, 26C) of these envelopes, several electronic arrangements (34, 34A, 34B) being provided and introduced respectively in said pockets.

9. Process according to claim 8, characterized in that said electronic arrangements (34, 34A, 34B) are initially connected to each other by a support (44), these electronic arrangements being located under said support with a regular spacing (50) corresponding to the spacing (48) of said provided envelopes (20, 20A, 20B, 20C), said electronic arrangements being simultaneously introduced into said pockets with the aid of said support, this support being separated from these electronic arrangements during said separation step in which the devices, respectively formed by said envelopes and said electronic arrangements embedded in said binding filling these envelopes are separated from said common reservoir.

10. Transponder (2; 70) capable of being obtained according to the process of manufacturing of any one of claims 1 to 9, comprising an electronic arrangement (3; 34) and a coating (10, 12; 20, 64) protecting this electronic arrangement, characterized in that said coating is formed by an external envelope (12; 20), defining a pocket and presenting an opening, and a solidified binding entirely filling said envelope and forming an external surface of said transponder in the region defined by said opening, said electronic arrangement being embedded in said binding.

11. Transponder according to claim 10, characterized in that said envelope (20) presents, in a region situated at an extremity opposite to said opening, a hole (54) of small cross-section.

12. Transponder according to claim 11, characterized in that said hole (54) opens into an external recess (56) formed in said envelope.

13. Transponder according to one of claim 10 to 12, characterized in that said binding (10; 20) is constituted by a two-component glue.

14. Transponder according to one of claim 10 to 13, characterized in that said envelope (12; 20) is formed from plastic material.

15. Transponder according to one of claim 10 to 14, characterized in that said electronic arrangement is formed by an integrated circuit (4; 42) and a coil (6; 40) electrically connected.
